# EUROPÄISCHE PATENTSCHRIFT

(11) **EP 1 952 536 B1**
(45) Veröffentlichungstag und Bekanntmachung des Hinweises auf die Patenterteilung: **13.02.2013**
(21) Anmeldenummer: 06830069.8
(22) Anmeldetag: 21.11.2006
(51) Int. Cl.: H03K 17/687, H03K 17/04

(54) **SCHALTUNGSANORDNUNG UND VERFAHREN ZUM ANSTEUERN EINES ELEKTRONISCHEN BAUELEMENTS MIT EINEM AUSGANGSSIGNAL EINES MIKROPROZESSORS**
CIRCUIT ARRANGEMENT AND METHOD FOR DRIVING AN ELECTRONIC COMPONENT WITH AN OUTPUT SIGNAL FROM A MICROPROCESSOR
CIRCUITERIE ET PROCEDE POUR COMMANDER UN COMPOSANT ELECTRONIQUE PAR LE BIAIS D'UN SIGNAL DE SORTIE D'UN MICROPROCESSEUR

(30) Priorität: 23.11.2005 DE 102005055832
(43) Veröffentlichungstag der Anmeldung: 06.08.2008
(73) Patentinhaber: OSRAM GmbH, 81543 München (DE)
(72) Erfinder: RUDOLPH, Bernd, 85659 Forstern (DE)
(86) Internationale Anmeldenummer: PCT/EP2006/068722
(87) Internationale Veröffentlichungsnummer: WO 2007/060165

(56) Entgegenhaltungen:
- EP-A2- 0 709 961
- GB-A- 2 110 030
- GB-A- 2 238 437
- US-A- 4 471 245
- US-A- 5 828 261

## Beschreibung

### Technisches Gebiet

Die vorliegende Erfindung betrifft eine Schaltungsanordnung zum Ansteuern eines elektronischen Bauelements mit einem Ausgangssignal eines Mikroprozessors, umfassend das elektronische Bauelement mit einem Steuereingang und den Mikroprozessor, der an einem Ausgang ein Ausgangssignal bereitstellt. Sie umfasst überdies ein entsprechendes Verfahren zum Ansteuern eines elektronischen Bauelements mit dem Ausgangssignal eines Mikroprozessors.

### Stand der Technik

Die vorliegende Erfindung ist vor dem Hintergrund zu sehen, dass Mikroprozessorsteuerungen zunehmend in die Leistungselektronik eindringen. Eine typische Anwendung dabei ist der Einsatz zur Ansteuerung von elektronischen Schalten mit isoliertem Gate, die statisch im Wesentlichen spannungsgesteuert sind, beispielsweise MOSFET, IGBT, ESBT, zum Beispiel für PFC (Power Factor Correction)-Stufen.

Eine unmittelbare Ansteuerung eines derartigen elektronischen Bauelements mit einem Signal, das der Mikroprozessor an einem Ausgang bereitstellt, welches üblicherweise einen Spannungshub in der Größenordnung von 5 V aufweist, wobei die Tendenz zu noch geringeren Spannungen geht, scheitert, da derartige elektronische Bauelemente an ihrem Steuereingang für eine zuverlässige Ansteuerung Spannungen von 10 V und mehr benötigen. Außerdem kann der Mikroprozessor leistungsstarke Schalten mit nennenswerten Eingangskapazitäten - der entsprechende P90SFET-Parameter lautet Total Gate Charge - nicht mit hohen Schaltgeschwindigkeiten betreiben, da die notwendigen Steuerströme nicht bereitgestellt werden können.

In der Schrift GB 2110030 (Shanley) ist eine Signalumsetzungs-Schaltung offenbart, die ein Signal über eine Basisschaltung in einen Stromspiegel einspeist.

In der Schrift GB 2238437 (Sidney) ist eine Treiberschaltung für einen Feld-Effekt-Transistor offenbart, bei der auf eine Emitterschaltung eine Kollektorschaltung folgt.

In der Schrift US 4471245 (Janutka) ist eine Treiberschaltung für einen Feld-Effekt-Transistor offenbart, bei der auf eine Emitterschaltung eine Basisschaltung folgt.

Zur Lösung der oben genannten Problematik werden gewöhnlich spezielle integrierte Treiberschaltungen eingesetzt, die den Pegel des Ausgangssignals des Mikroprozessors auf ein Niveau bringen, das zur Ansteuerung des elektronischen Bauelements geeignet ist und für hohe Schaltgeschwindigkeiten entsprechend hohe Ausgangsströme erzeugen können. Die Verwendung. derartiger Treiberschaltungen ist jedoch aufgrund deren Komplexität und der damit einhergehenden hohen Kosten unvorteilhaft.

### Darstellung der Erfindung

Die Aufgabe der vorliegenden Erfindung besteht deshalb darin, eine Möglichkeit bereitzustellen, mit der auf kostengünstige Art und Weise ein elektronisches Bauelement mit dem Ausgangssignal eines Mikroprozessors angesteuert werden kann.

Diese Aufgabe wird einerseits gelöst durch eine Schaltungsanordnung mit den Merkmalen von Patentanspruch 1 sowie andererseits durch ein Verfahren mit den Merkmalen von Patentanspruch 11.

Der vorliegenden Erfindung liegt die Erkenntnis zugrunde, dass die oben bezeichnete Aufgabe gelöst werden kann, wenn eine Kombination aus zwei bipolaren Transistoren als Teil einer Treiberstufe zwischen den Ausgang des Mikroprozessors und den Steuereingang des elektronischen Bauelements geschaltet wird, wobei der mit dem Mikroprozessor verbundene Bipolartransistor in Basisschaltung geschaltet ist. Dieser treibt den weiteren Bipolartransistor, der in Emitterschaltung arbeitet. Dadurch wird zum einen eine hohe Schaltgeschwindigkeit auch mit preisgünstigen Standardbauteilen gewährleistet, d. h. es müssen keine speziellen HF-Transistoren verwendet werden, zum anderen liegt der Vorteil der erfindungsgemäßen Schaltungsanordnung darin, dass bei Ausfall der Versorgungsspannung der diese zwei Bipolartransistoren umfassenden Treiberstufe kein Strom in den betreffenden Ausgang des Mikroprozessors fließt und dessen logischen Zustand beeinflusst.

Durch die Ansteuerung des ersten Bipolartransistors an dessen Emitterseite kann ein größerer Strom verwendet werden, als wenn dieser Bipolartransistor über seine Basisseite angesteuert würde. Die Basis des ersten Bipolartransistors ist dabei mit dem Bezugspotential gekoppelt ist, mit dem der Mikroprozessor über einen seiner Eingänge, insbesondere zur Spannungsversorgung, gekoppelt ist.

Um hohe Schaltgeschwindigkeiten auch mit preisgünstigen Standardbauteilen sicherzustellen, kann zwischen den Kollektor des ersten Bipolartransistors und die Basis des zweiten Bipolartransistors eine erste Antisättigungsdiode und zwischen den Kollektor des ersten Bipolartransistors und den Kollektor des zweiten Bipolartransistors eine zweite Antisättigungsdiode gekoppelt sein.

Um ein schnelles Ausschalten des elektronischen Bauelements zu ermöglichen, umfasst die erfindungsgemäße Schaltungsanordnung bevorzugt einen weiteren Transistor, bevorzugt einen Logic-Level-MOSFET, insbesondere einen n-Kanal-MOSFET, dessen Steuerelektrode mit dem Ausgang des Mikroprozessors, dessen Bezugselektrode mit einem zweiten Bezugspotential, insbesondere mit Masse, und dessen Arbeitselektrode mit dem Steuereingang des elektronischen Bauelements gekoppelt ist. Damit lässt sich überdies der Vorteil einer sehr geringen Ruhestromaufnahme einer erfindungsgemäßen Schaltungsanordnung erzielen.

Bevorzugt ist der Steuereingang des elektronischen Bauelements über einen Pull-Down Widerstand mit dem zweiten Bezugspotential gekoppelt, damit das elektronische Bauelement auch ohne aktive Steuerschaltung im Ruhezustand sicher gesperrt ist.

Der Spannungshub des Ausgangssignals am Ausgang des Mikroprozessors beträgt bevorzugt maximal 6 V. Bevorzugt ist der erste Bipolartransistor vom npn-Typ, der zweite Bipolartransistor vom pnp-Typ. Wie bereits erwähnt, handelt es sich bei dem elektronischen Bauelement um ein im Wesentlichen Spannungsgesteuertes elektronisches Bauelement, insbesondere einen MOSFET, einen IGBT oder einen ESBT.

Weitere bevorzugte Ausführungformen ergeben sich aus den Unteransprüchen.

Die im Zusammenhang mit der erfindungsgemäßen Schaltungsanordnug erwähnten bevorzugten Ausführungsformen und deren Vorteile gelten im entsprechender Weise für das erfindungsgemäße Verfahren.

### Kurze Beschreibung der Zeichnung(en)

Im Nachfolgenden wird nun ein Ausführungsbeispiel einer erfindungsgemäßen Schaltungsanordnung unter Bezugnahme auf die beigefügten Zeichnungen näher beschrieben. Diese zeigen:
- Fig. 1: in schematischer Darstellung einen Schaltplan eines Ausführungsbeispiels einer erfindungsgemäßen Schaltungsanordnung;
- Fig. 2: den zeitlichen Verlauf verschiedener Größen der Schaltungsanordnung von Fig. 1 beim Ein- und Ausschalten eines MOSFET;
- Fig. 3: den zeitlichen Verlauf verschiedener Größen der Schaltungsanordnung von Fig. 1 in vergrößerter Darstellung beim Einschalten eines MOSFET; und
- Fig. 4: den zeitlichen Verlauf verschiedener Größen der Schaltungsanordnung von Fig. 1 in vergrößerter Darstellung beim Ausschalten eines MOSFET.

### Bevorzugte Ausführung der Erfindung

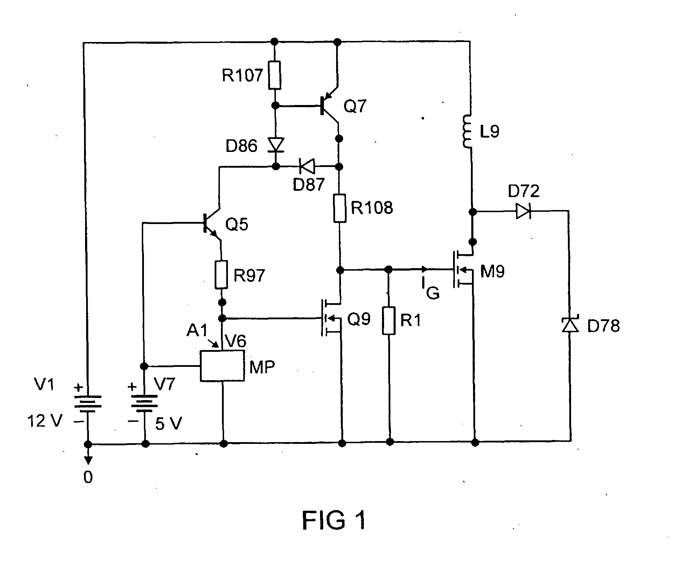

Fig. 1 zeigt in schematischer Darstellung den Schaltplan eines bevorzugten Ausführungsbeispiels einer erfindungsgemäßen Schaltungsanordnung. Einige der elektronischen Bauelemente sind, wie für den Fachmann im Hinblick auf die nachfolgenden Ausführungen offensichtlich, simulationsbedingt. Die Schaltungsanordnung umfasst einen Mikroprozessor MP, an dessen Ausgang A1 ein Ausgangssignal V6 bereitgestellt wird. Dieses Ausgangssignal wird über einen Widerstand R97 an den Emitter eines Bipolartransistors Q5 in Basisschaltung angelegt. Dessen Basis liegt auf dem Bezugspotential V7, das im Ausführungsbeispiel 5 V beträgt und gleichzeitig der Versorgung des Mikroprozessors MP dient. Der Kollektor des Bipolartransistors Q5 ist mit der Basis eines zweiten Bipolartransistors Q7 verbunden, der in Emitterschaltung betrieben wird. Der Kollektor des zweiten Bipolartransistors ist über einen Widerstand R108 mit dem Steuereingang, d. h. dem Gate eines Leistungsschalters, realisiert durch den MOSFET-Transistor M9, verbunden. Zwischen den Kollektor des ersten Bipolartransistors Q5 und die Basis des zweiten Bipolartransistors Q7 ist eine erste Antisättigungsdiode D86, zwischen den Kollektor des ersten Bipolartransistors Q5 und den Kollektor des zweiten Bipolartransistors Q7 eine zweite Antisättigungsdiode D87 gekoppelt. Das Gate des Feldeffekttransistors M9 ist mit dem Drainanschluß eines Feldeffekttransistors Q9 gekoppelt, dessen Source auf Masseanschluss liegt, während dessen Gate mit dem Ausgang A1 des Mikroprozessors MP verbunden ist. Zwischen das Gate des Feldeffekttransistors M9 und den Masseanschluss ist ein Pull-Down Widerstand R1 gekoppelt. Zur Simulation einer induktiven Last ist eine Induktivität L9 mit dem Drainanschluss des Feldeffekttransistors verbunden, wobei der Drainanschluss überdies über die Serienschaltung einer Diode D72 und einer Zenerdiode D78 mit dem Massepotential verbunden ist. Die Treiberstufe, umfassend die Bipolartransistoren Q5 und Q7, sowie der Feldeffekttransistor Q9 und der Feldeffekttransistor M9 werden versorgt aus einer Spannungsquelle V1, die vorliegend eine Spannung von 12 V bereitstellt.

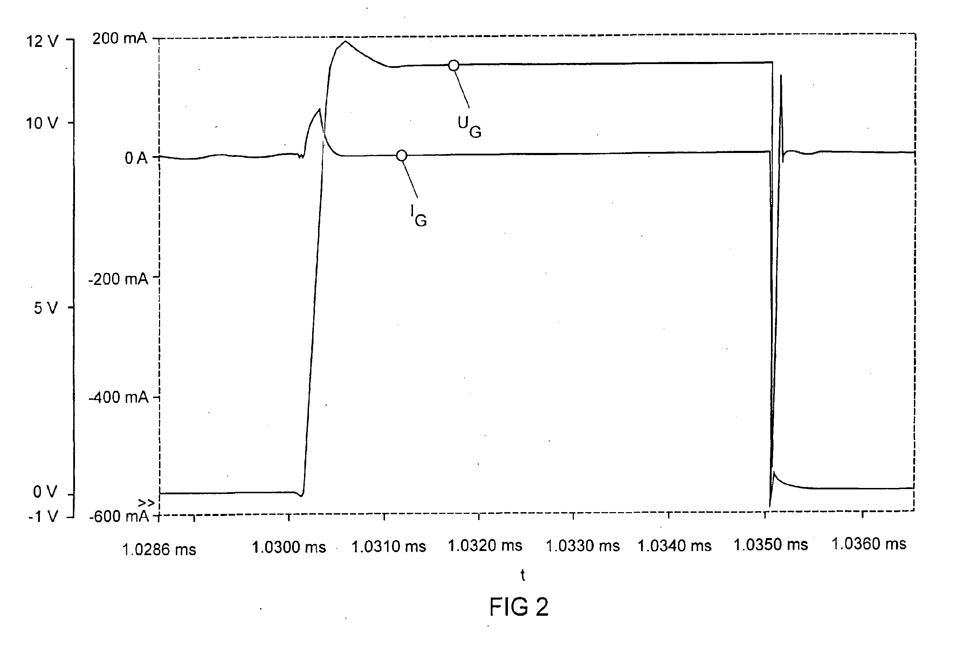

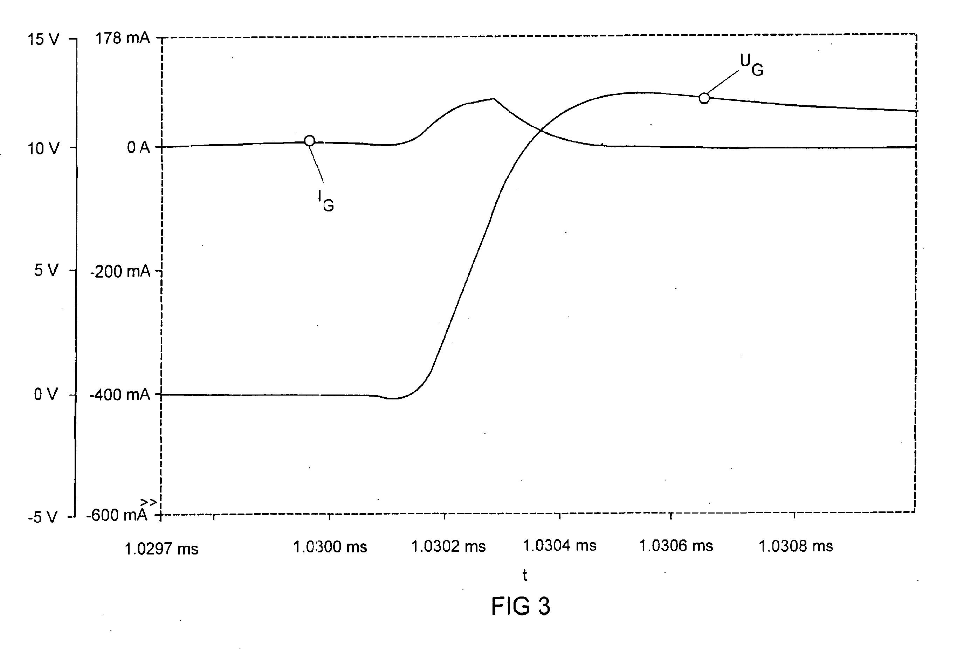

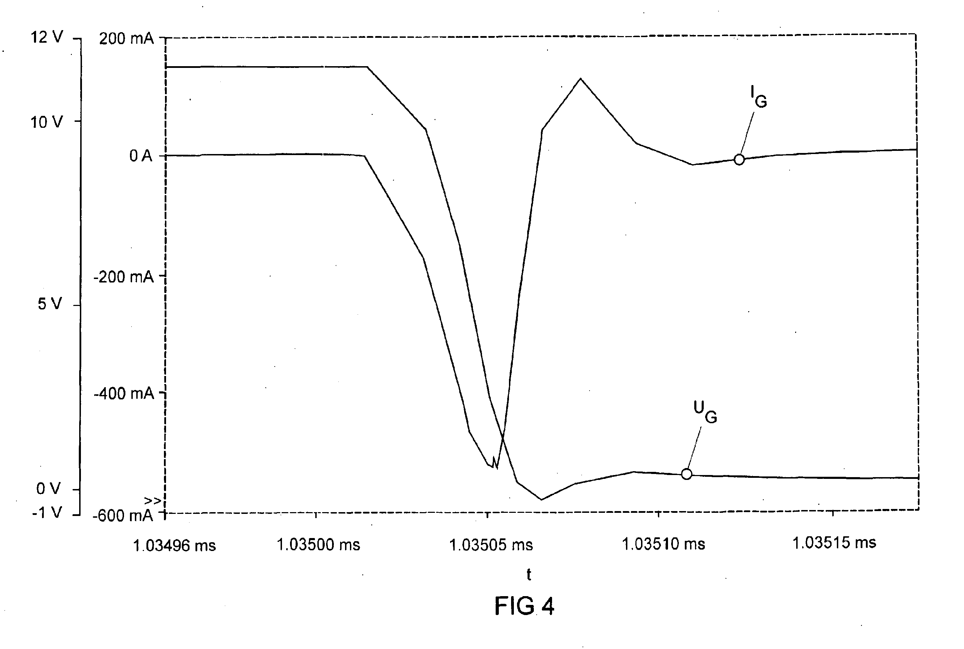

Fig. 2 zeigt den zeitlichen Verlauf des Gatestroms I_{G} sowie der Gatespannung U_{G} des Feldeffekttransistors M9 beim Einschalten (linke Bildhälfte) sowie beim Ausschalten (rechte Bildhälfte).Der Einschaltvorgang ist deutlicher zu sehen in Fig. 3, der Ausschaltvorgang deutlicher in Fig. 4, auf die nachfolgend Bezug genommen wird.

Zum Einschalten des Feldeffekttransistors M9 wird zunächst am Ausgang A1 des Mikroprozessors MP ein Massepotential angelegt, wodurch der erste Bipolartransistor Q5 einschaltet. Ein Einschalten des ersten Bipolartransistors Q5 bewirkt ein Einschalten des zweiten Bipolartransistors Q7, der daraufhin einen Kollektorstrom erzeugt, der im Wesentlichen als Gatestrom I_{G} in das Gate des Feldeffekttransistors M9 fließt. Der zweite Feldeffekttransistor Q9 ist infolgedessen, dass die Spannung am Ausgang A1 des Mikroprozessors MP auf Massepotential liegt, zunächst gesperrt. Durch die Überschwemmung des Gates des Feldeffekttransistors M9 mit Ladungsträgern wird der Feldeffekttransistor innerhalb von 200 ns eingeschaltet, siehe den Anstieg der Gatespannung U_{G} des Feldeffekttransistors M9 von 0 V auf ca. 12 V in Fig. 3.

Zum Ausschalten des Feldeffekttransistors M9 wird am Ausgang A1 des Mikroprozessors MP ein 5 V-Signal bereitgestellt, wodurch der Bipolartransistor Q5 sperrend, der Feldeffekttransistor Q9 leitend wird. Dadurch wird der Gateanschluss des Feldeffekttransistors M9 mit dem Massepotential verbunden und ein Abfließen von Ladungsträgern aus dem Gate von M9 ermöglicht, was in einem Gatestrom I_{G} mit negativer Amplitude resultiert. Der Überschwinger resultiert aus einer Schwingung infolge der Miller-Kapazität des Feldeffekttransistors M9 und der induktiven Last L9. Nach dem Entladen des Gates geht der Gatestrom I_{G} wieder auf 0 A zurück. Der Gatestrom I_{G} mit negativer Amplitude führt zu einem Ausschalten des Feldeffekttransistors M9 innerhalb von 20 ns, siehe den Verlauf der Gatespannung U_{G} in Fig. 4.

Würden die beiden Bipolartransistoren der Treiberstufe als Emitterfolger betrieben, d. h. in Kollektorschaltung, könnten derart kurze Schaltzeiten, wie in den Figuren 3 und 4 dargestellt, nicht erzielt werden. Im ausgeschalteten Zustand, d. h. der Bipolartransistor Q5 ist gesperrt, dadurch ist der Bipolartransistor Q7 gesperrt, der Feldeffekttransistor Q9 ist leitend, der Feldeffekttransistor M9 ist ausgeschaltet, liegt die Ruhestromaufnahme bei 0. Eine Verbesserung der in Fig. 1 dargestellten Schaltungsanordnung lässt sich erreichen, wenn am Ausgang des Feldeffekttransistors Q9 ein Pull-Down Widerstand R1 angeordnet wird, der in der Anlaufphase der Gesamtschaltung dafür sorgt, dass der MOSFET M9 sicher gesperrt ist.

Die in Fig. 1 dargestellte Schaltungsanordnung arbeitet weiterhin ohne Probleme, die durch Inversbetrieb des in Emitterschaltung betriebenen Transistors Q5 bei einer Versorgungsspannung V1 < V7 hervorgerufen sein könnten. Der Ausgang des Mikroprozessors MP würde dadurch unter Umständen von außen auf eine zu niedrige Spannung geklemmt werden, die die Funktion des Mikroprozessors MP negativ beeinflussen könnte. Dies könnte überdies zu einer Zerstörung des Mikroprozessors MP durch Überlastung seines Ausgangs führen. Bei der erfindungsgemäßen Lösung, wird dieses Problem durch die Verwendung der Antisättigungsdioden D86 und D87, die gleichzeitig als Inversschutzdioden für den Transistor Q5 dienen, vermieden. Werden diese Dioden nicht verwendet, lässt sich dieses Problem lösen, wenn der Mikroprozessor MP auf logisch High oder Tristate hochohmig geschaltet ist.

In den zeitlichen Verläufen von Fig. 2 bis Fig. 4 wurden in dem zugrunde gelegten Ausführungsbeispiel die elektronischen Halbleiter-Bauelemente der Schaltungsanordnung von Fig. 1 durch folgende Bauteile realisiert: Q5 durch einen BC846A, Q7 durch einen BC807-40, D86 und D87 durch jeweils eine D1N4148, Q9 durch einen BSS87/SIE, M9 durch einen IRF830, D72 durch eine D1N4937, D78 durch eine D1N5254. Preisgünstige Alternativen für Q9 wären beispielsweise ein BSS98, ein BSS123 sowie ein 2N7002.

## Patentansprüche

1. Schaltungsanordnung zum Ansteuern eines elektronischen Bauelements mit dem Ausgangssignal (V6) eines Mikroprozessors (MP), umfassend:
- das elektronischen Bauelement mit einem Steuereingang;
- einen Mikroprozessor (MP), der an einem Ausgang (A1) ein Ausgangssignal (V6) bereitstellt;
- einen ersten Bipolartransistor (Q5) in Basisschaltung, dessen Emitter mit dem Ausgang (A1) des Mikroprozessors (MP) gekoppelt ist;
- einen zweiten Bipolartransistor (Q7) in Emitterschaltung, dessen Basis mit dem Kollektor des ersten Bipolartransistors (Q5) gekoppelt ist, wobei der Kollektor des zweiten Bipolartransistors (Q7) mit dem Steuereingang des elektronischen Bauelements gekoppelt ist,
**dadurch gekennzeichnet,**
**dass** der Mikroprozessor (MP) einen Eingang aufweist, über den er mit einem ersten Bezugspotential (V7) gekoppelt ist, wobei die Basis des ersten Bipolartransistors (Q5) mit dem Bezugspotential (V7) des Mikroprozessors (MP) gekoppelt ist..

2. Schaltungsanordnung nach Anspruch 1,
**dadurch gekennzeichnet,**
**dass** zwischen den Kollektor des ersten Bipolartransistors (Q5) und die Basis des zweiten Bipolartransistors (Q7) eine erste Antisättigungsdiode (D86) und zwischen den Kollektor des ersten Bipolartransistors (Q5) und den Kollektor des zweiten Bipolartransistors (Q7) eine zweite Antisättigungsdiode (D87) gekoppelt ist.

3. Schaltungsanordnung nach einem der vorhergehenden Ansprüche,
**dadurch gekennzeichnet,**
**dass** sie einen weiteren Transistor (M9), bevorzugt einen MOSFET, insbesondere einen n-Kanal MOSFET, umfasst, dessen Steuerelektrode mit dem Ausgang (A1) des Mikroprozessors (MP), dessen Bezugselektrode mit einem zweiten Bezugspotential, insbesondere mit Masse, und dessen Arbeitselektrode mit dem Steuereingang des elektronischen Bauelements gekoppelt ist.

4. Schaltungsanordnung nach Anspruch 3,
**dadurch gekennzeichnet,**
**dass** der Steuereingang des elektronischen Bauelements über einen Pull-Down Widerstand (R1) mit dem zweiten Bezugspotential gekoppelt ist.

5. Schaltungsanordnung nach einem der vorhergehenden Ansprüche,
**dadurch gekennzeichnet,**
**dass** der Spannungshub des Ausgangssignals (V6) am Ausgang (A1) des Mikroprozessors (MP) maximal 6 V beträgt.

6. Schaltungsanordnung nach einem der vorhergehenden Ansprüche,
**dadurch gekennzeichnet,**
**dass** der erste Bipolartransistor (Q5) vom npn-Typ ist.

7. Schaltungsanordnung nach einem der vorhergehenden Ansprüche,
**dadurch gekennzeichnet,**
**dass** der zweite Bipolartransistor (Q7) vom pnp-Typ ist.

8. Schaltungsanordnung nach einem der vorhergehenden Ansprüche,
**dadurch gekennzeichnet,**
**dass** das elektronischen Bauelement ein im wesentlichen spannungsgesteuertes elektronischen Bauelement ist.

9. Schaltungsanordnung nach einem der vorhergehenden Ansprüche,
**dadurch gekennzeichnet,**
**dass** das elektronische Bauelement ein MOSFET, ein IGBT oder ein ESBT ist.

10. Verfahren zum Ansteuern eines elektronischen Bauelements mit dem Ausgangssignal (V6) eines Mikroprozessors (MP), **gekennzeichnet durch** folgende Schritte:
a) das Ausgangssignal (V6) des Mikroprozessors (MP) wird an den Emitter eines ersten Bipolartransistors (Q5) in Basisschaltung gekoppelt;
b) der Kollektor des ersten Bipolartransistors (Q5) wird mit der Basis eines zweiten Bipolartransistors (Q7) in Emitterschaltung gekoppelt, wobei der Kollektor des zweiten Bipolartransistors (Q7) mit dem Steuereingang des elektronischen Bauelements gekoppelt wird,
c) ein Eingang des Mikroprozessor (MP) wird mit einem ersten Bezugspotential (V7) gekoppelt, wobei die Basis des ersten Bipolartransistors (Q5) mit dem ersten Bezugspotential (V7) des Mikroprozessors (MP) gekoppelt wird.

## Claims

1. Circuit arrangement for driving an electronic component with the output signal (V6) from a microprocessor (MP), comprising:
- the electronic component with a control input;
- a microprocessor (MP), which provides an output signal (V6) at an output (A1);
- a first bipolar transistor (Q5) in common-base connection, the emitter of which is coupled to the output (A1) of the microprocessor (MP);
- a second bipolar transistor (Q7) in common-emitter connection, the base of which is coupled to the collector of the first bipolar transistor (Q5), the collector of the second bipolar transistor (Q7) being coupled to the control input of the electronic component,
**characterized**
**in that** the microprocessor (MP) has an input via which it is coupled to a first reference potential (V7), the base of the first bipolar transistor (Q5) being coupled to the reference potential (V7) of the microprocessor (MP).

2. Circuit arrangement according to Claim 1,
**characterized**
**in that** a first antisaturation diode (D86) is coupled between the collector of the first bipolar transistor (Q5) and the base of the second bipolar transistor (Q7) and a second antisaturation diode (D87) is coupled between the collector of the first bipolar transistor (Q5) and the collector of the second bipolar transistor (Q7).

3. Circuit arrangement according to any of the preceding claims,
**characterized**
**in that** it comprises a further transistor (M9), preferably a MOSFET, in particular an n-channel MOSFET, the control electrode of which is coupled to the output (A1) of the microprocessor (MP), the reference electrode of which is coupled to a second reference potential, in particular to ground, and the working electrode of which is coupled to the control input of the electronic component.

4. Circuit arrangement according to Claim 3,
**characterized**
**in that** the control input of the electronic component is coupled to the second reference potential via a pull-down resistor (R1).

5. Circuit arrangement according to any of the preceding claims,
**characterized**
**in that** the voltage swing of the output signal (V6) at the output (A1) of the microprocessor (MP) is at most 6 V.

6. Circuit arrangement according to any of the preceding claims,
**Characterized in that** the first bipolar transistor (Q5) is of the npn type.

7. Circuit arrangement according to any of the preceding claims,
**characterized**
**in that** the second bipolar transistor (Q7) is of the pnp type.

8. Circuit arrangement according to any of the preceding claims,
**characterized**
**in that** the electronic component is an essentially voltage-controlled electronic component.

9. Circuit arrangement according to any of the preceding claims,
**characterized**
**in that** the electronic component is a MOSFET, an IGBT or an ESBT.

10. Method for driving an electronic component with the output signal (V6) from a microprocessor (MP), **characterized by** the following steps:
a) the output signal (V6) of the microprocessor (MP) is coupled to the emitter of a first bipolar transistor (Q5) in common-base connection;
b) the collector of the first bipolar transistor (Q5) is coupled to the base of a second bipolar transistor (Q7) in common-emitter connection, the collector of the second bipolar transistor (Q7) being coupled to the control input of the electronic component,
c) an input of the microprocessor (MP) is coupled to a first reference potential (V7), the base of the first bipolar transistor (Q5) being coupled to the first reference potential (V7) of the microprocessor (MP).

## Revendications

1. Agencement de circuit destiné à commander un composant électronique à l'aide du signal de sortie (V6) d'un microprocesseur (MP), comprenant :
- le composant électronique doté d'une entrée de commande ;
- un microprocesseur (MP) qui fournit un signal de sortie (V6) au niveau d'une sortie (A1) ;
- un premier transistor bipolaire (Q5) à montage en base commune, dont l'émetteur est couplé à la sortie (A1) du microprocesseur (MP) ;
- un deuxième transistor bipolaire (Q7) à montage en émetteur commun, dont la base est couplée au collecteur du premier transistor bipolaire (Q5), le collecteur du deuxième transistor bipolaire (Q7) étant couplé à l'entrée de commande du composant électronique,
**caractérisé en ce que**
le microprocesseur (MP) comporte une entrée par l'intermédiaire de laquelle il est couplé à un premier potentiel de référence (V7), la base du premier transistor bipolaire (Q5) étant couplée au potentiel de référence (V7) du microprocesseur (MP).

2. Agencement de circuit selon la revendication 1,
**caractérisé en ce que**
une première diode antisaturation (D86) est couplée entre le collecteur du premier transistor bipolaire (Q5) et la base du deuxième transistor bipolaire (Q7) et une deuxième diode antisaturation (D87) est couplée entre le collecteur du premier transistor bipolaire (Q5) et le collecteur du deuxième transistor bipolaire (Q7).

3. Agencement de circuit selon l'une des revendications précédentes,
**caractérisé en ce que**
il comprend un autre transistor (M9), de préférence un MOSFET, en particulier un MOSFET à canal n, dont l'électrode de commande est couplée à la sortie (A1) du microprocesseur (MP), dont l'électrode de référence est couplée à un deuxième potentiel de référence, en particulier à la masse, et dont l'électrode de travail est couplée à l'entrée de commande du composant électronique.

4. Agencement de circuit selon la revendication 3,
**caractérisé en ce que**
l'entrée de commande du composant électronique est couplée au deuxième potentiel de référence par l'intermédiaire d'une résistance pull-down (R1).

5. Agencement de circuit selon l'une des revendications précédentes,
**caractérisé en ce que**
l'excursion de tension du signal de sortie (VG) au niveau de la sortie (A1) du microprocesseur (MP) est au maximum de 6 V.

6. Agencement de circuit selon l'une des revendications précédentes,
**caractérisé en ce que**
le premier transistor bipolaire (Q5) est du type npn.

7. Agencement de circuit selon l'une des revendications précédentes,
**caractérisé en ce que**
le deuxième transistor bipolaire (Q7) est du type pnp.

8. Agencement de circuit selon l'une des revendications précédentes,
**caractérisé en ce que**
le composant électronique est un composant électronique qui est essentiellement commandé en tension.

9. Agencement de circuit selon l'une des revendications précédentes,
**caractérisé en ce que**
le composant électronique est un MOSFET, un IGBT ou un ESBT.

10. Procédé destiné à commander un composant électronique à l'aide du signal de sortie (V6) d'un microprocesseur (MP), **caractérisé par** les étapes suivantes consistant à:
a) coupler le signal de sortie (V6) du microprocesseur (MP) à l'émetteur d'un premier transistor bipolaire (Q5) à montage en base commune ;
b) coupler le collecteur du premier transistor bipolaire (Q5) à la base d'un deuxième transistor bipolaire (Q7) à montage en émetteur commun, le collecteur du deuxième transistor bipolaire (Q7) étant couplé à l'entrée de commande du composant électronique,
c) coupler une entrée du microprocesseur (MP) à un premier potentiel de référence (V7), la base du premier transistor bipolaire (Q5) étant couplée au premier potentiel de référence (V7) du microprocesseur (MP).
